Europäisches Patentamt

European Patent Office

Office européen des brevets

(19)

(11) Publication number: **0 277 653 B1**

(12) **EUROPEAN PATENT SPECIFICATION**

(45) Date of publication of patent specification: **16.12.92**　(51) Int. Cl.⁵: **H02K 3/26**

(21) Application number: **88101557.2**

(22) Date of filing: **03.02.88**

(54) **Pancake armature.**

(30) Priority: **05.02.87 US 11056**

(43) Date of publication of application:
**10.08.88 Bulletin 88/32**

(45) Publication of the grant of the patent:
**16.12.92 Bulletin 92/51**

(84) Designated Contracting States:
**DE FR GB**

(56) References cited:
**EP-A- 0 203 204**
**DE-A- 1 613 408**
**DE-A- 2 744 911**
**US-A- 3 456 144**

(73) Proprietor: **MICA CORPORATION**
**8536 National Boulevard**
**Culver City California 90230(US)**

(72) Inventor: **Harshad, Uka K.**
**8686 Venice Boulevard**
**Los Angeles California 90034(US)**

(74) Representative: **Wey, Hans-Heinrich, Dipl.-Ing.**
**c/o Kanzlei Hansmann, Vogeser und Partner**
**Albert Rosshaupter-Strasse 65**
**W-8000 München 70(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

This invention relates to disc-type armatures (so-called "pancake" armatures) for electric machines such as electric motors, that comprise two or more layers of electrically conductive circuit patterns, each pair of which is separated by an insulating layer, and that are conductively connected to unite the patterns in a single continuous electrical circuit.

Disc-type armatures having two or four arrays of radially extending aluminum or copper winding segments in a flat profile of parallel planes, separated by dielectric material, having overlapping tabs on adjacent arrays at inner and outer annular boundaries welded together to connect to form a "closed wave winding", are well known. They are disclosed, for instance, in U.S. Patents Nos. 3,450,909, 3,450,918, 3,480,815, 3,488,539, 3,500,095, and 3,549,928. If the segments are aluminum, the structure described includes a copper brush track coated on the segments on one of the arrays. It is suggested in these patents that the arrays may be formed as metal stampings.

A stamping operation yields layers of conductors that may be self-supporting and can be conveniently assembled in parallel planes separated by dielectric material, but since a so-called "blanking die" is needed for creating the conductors, any change in configuration requires time consuming and expensive die changes. Also, the welding operation is difficult to control; any error in the power setting results in a burned out weld, and if there is any contamination between the layers in the tab area, the joint may be partially or completely non-conductive.

Two-faced armatures forming the rotors for electric motors and comprising two layers of half-turn conductive windings defined by photo-etching or masked printing techniques on the opposite annular faces of an insulating disc-shaped carrier are disclosed, for instance, in U.S. Patents Nos. 3,144,574, 3,231,774, 3,223,870, and 4,341,973, in which the windings on each face are interconnected by brazed or welded tabs on the periphery or by metallizing holes extending from one set of half-turn wound conductors to the other. Such "through-hole" metallization is shown particularly in Nos. 3,231,774 and 3,223,870, and also in U.S. Patents 3,046,427, 3,091,715, and 3,159,764.

However, these structures are not suitable for the construction of efficient motors since the involved circuitry is conventionally limited by the presence of only two conductive layers and the lack of suitable techniques for the manufacture of four or more conductive layers of winding segments. There is a need for a disc-type armature with four or more layers of windings that operates with greater efficiency, by developing more torque and generating less heat per unit of electricity, and particularly for more efficient techniques for their manufacture on a mass production basis, to meet the needs of high-volume applications such as personal computers.

According to the invention, a method for making a pancake armature comprising using print masking to etch or deposit on both sides of an insulating separator a half-turn electric circuit pattern and thereby create a pair of conductive layers on the insulating separator, and electrically interconnecting the conductive layers by a metallized hole extending through the conductive layers and the insulating separator, is characterized in that an outer insulating separator is placed in contact with each of the pair of conductive layers and an additional conductive layer having areas in registration with the adjacent one of the said previously printed inner electric circuit patterns is applied to each of the outer insulating separators by using similar masking to etch or deposit on the outer insulating separators complementary outer half-turn electric circuit patterns, the insulating outer separators are adhesively laminated to the conductive layers to form a rigid unitary multilayer laminate, and each of the said outer half-turn electric circuit patterns is connected to the adjacent one of the said previously printed half-turn electric circuit patterns by a metallized hole extending through the respective conductive layers and the outer insulating separator to unite the four printed electric circuit patterns into a single continuous electrical circuit.

Preferably, in the method according to the invention, the assembly of the unitary multilayer laminate includes the steps of applying on each face of the said said previously printed half-turn electric circuit patterns an outer insulating separator and a sheet of conductive material, applying heat and pressure to adhere the layers of the assembly together, applying on each face of the multilayer laminate a layer of photoresist material and a printing mask having areas opaque to ultraviolet light corresponding to and in circuit registration with the said electric circuit patterns, exposing each face of the multilayer laminate to ultraviolet light, removing the masks, washing and etching each face, and removing the masks and unexposed photoresist material.

It is also preferable to incorporate in each of the insulating separators on which the two outer conductive layers are printed is incorporated an outer surface layer of material that is softer than the other material of the insulating separators, and pressure is applied to both conductive faces of the unitary multilayer laminate to embed at least partially the projecting outer electric circuit patterns into the said softer surface layer.

Also preferably, in the method according to the invention, a predetermined number of the said half-turn electric circuit patterns are etched or deposited in spaced-apart relationship on both sides of the insulating separator, which with the other components of the unitary multilayer laminate and the layer of photoresist material are dimensioned to comprise the same number of pancake armatures, and the steps in the assembly of the multilayer laminate include applying on each of its faces a mask having the same number of areas opaque to ultraviolet light corresponding to and in circuit registration with the said half-turn electric circuit patterns, and after the masks are removed the multilayer laminate is cut into a plurality of circles each comprising one pancake armature.

Also according to the invention, a pancake armature suitable for use in an electric motor, comprising a pair of half-turn electric circuit patterns etched or deposited on a self-supporting insulating separator and electrically interconnected by through-hole conductive connections each passing through the insulating separator to unite the printed electric circuit patterns into a single continuous electrical circuit, is characterized in that it comprises a rigid laminate constituted by two or more pairs of half-turn electric circuit patterns etched or deposited on three or more insulating separators and electrically interconnected by through-hole conductive connections each passing through one insulating separator and uniting the four printed electric circuit patterns into a single continuous electrical circuit.

Preferably, in a pancake armature according to the invention, an outer half-turn electric circuit pattern is etched or deposited on an outer insulating separator that is laminated on each face of the laminated pair of conductive layers and each of the said outer half-turn electric circuit patterns is in complementary registration with and electrically connected by through-hole conductive connections to the adjacent one of the said previously printed half-turn electric circuit patterns by metallized holes extending through the respective conductive layers and the outer insulating separator and uniting the four printed electric circuit patterns into a single continuous electrical circuit.

Also preferably, in a pancake armature according to the invention, the material of the outer surface layer of each of the insulating separators adjacent the two outer conductive layers is softer than the remainder of the said insulating separators, and the projecting outer electric circuit patterns is at least partially embedded in the said softer surface layer.

It should be noted that in a pancake armature according to the normally preferred form of the invention, the outer extremities of the electric circuit patterns that are etched or deposited on the insulating separators are spaced from the periphery of the laminate constituting the armature whereby the edges of the electric circuit patterns are protected by the insulating layers at the periphery of the armature.

Preferably, in a pancake armature according to the invention, short radial lines are etched or deposited near the periphery of the armature to reflect a source of light and act as a tachometer.

This invention provides a flexible choice of conductive metal layers and insulating substrates, depending upon the application. The conductive cladding layer can include any metal conventionally used for the purpose, such as copper, aluminum, nickel, and stainless steel. Aluminum-copper composite (aluminum foil or plate cladded with a thin foil of copper) has the advantage of aluminum's lower inertia (because of lower density) and copper's lower brush-contact resistance and high conductivity; the copper is removed in the final process from all the areas except the brush contact region. For example, if it is necessary to reduce weight, partially copper-clad aluminum substrate is used in place of copper.

The substrate that forms the insulating layer and the main supporting structure for the armature can include for example, mylar coated with adhesive (providing low inertia and convenient for lamination), polyimide film coated with an adhesive, paper reinforced with phenolic resin (an inexpensive, rigid and self supporting material), epoxy-impregnated fiberglass, and special substrates having specific electrical properties, such as a specific dielectric constant, dissipation factor, or dielectric loss factor; Teflon and polysulfone are examples of these. For instance, if it is necessary to reduce the dielectric constant of the insulation, a Teflon or polysulfone substrate is used in place of an epoxy substrate. Polymer-containing substrates that can be prepared with a layer of softer material are useful for the outer insulating layers if the outer conductive elements are to be partially embedded into the substrate.

It is possible to make individual insulating layers from extremely flexible substrate material by inserting a reinforcing layer in the construction. Ribs inthe form of spokes or simply concentric rings can be incorporated to provide mechanical support for the armature.

Referring to the drawings, in which the same reference character designates the same element in all the figures,

Figure 1 is included to illustrate the background prior art; it is a top plan view illustrating the metal stamping used to form the conductor arrays in the armature of the prior art of United States Patent No. 3,450,918;

Figure 2 is a cross sectional view of the four-layer armature formed from the stamping shown in Figure 1;

Figure 3 is an exploded perspective view of the inner layering of material used to form the armatures according to the present invention;

Figure 4 is a sectional view of the layers of Figure 3 in an assembled laminate;

Figure 5 shows the application of a photoresist layer to each of the conductive outer copper faces of the laminate of Figure 4;

Figure 6 is a perspective view showing the arrangement of masking "artwork" over each of the photoresist layers of Figure 5;

Figure 7 is an enlarged top plan view of the corner of the upper piece of the mask shown in Figure 6;

Figure 8 is similar to Figure 7 and shows an enlarged top plan view of the corner of the lower piece of the mask shown in Figure 6;

Figure 9 is a sectional view of one preferred embodiment of an intermediate assembly in the process according to the invention, showing the means for holding the masks in place against the photoresistive layers;

Figure 10 is similar to Figure 9, showing an alternative means for holding the masks in place where the holding means passes through the laminate and photoresist layers;

Figure 11 shows in sectional view the application of ultraviolet light through the masks to selectively harden the photoresist in the exposed areas;

Figure 12 shows the assembly of Figure 11 following the removal of the masks, the washing away of the unexposed photoresist on both sides, and the selective etching of conductive layers in those areas that were not masked by the ultraviolet light-hardened photoresist;

Figure 13 shows the laminated pair of conductive layers of Figure 12 following removal of the hardened photoresist;

Figure 14 is an exploded perspective view showing the arrangement of the outer layers of non-conductive substrate and the conductive cladding layers on the laminated pair of conductive layers depicted in Figure 13;

Figure 15 is a top plan view taken at the corner of the laminated pair of conductive layers shown in Figure 14;

Figure 16 is a sectional view through the assembly resulting from the combination of elements shown in Figure 14;

Figure 17 shows the assembly of Figure 16 with the photoresist applied to both outer conductive layers and masks in superposed but non-abutting position;

Figure 18 is an enlarged top plan view of one of the masks of Figure 17 at the corner indicated;

Figure 19 is an enlarged top plan view of the other of the masks of Figure 17 at the corner indicated;

Figure 20 is a sectional view of the elements of Figure 17 with the masks in abutting relationship;

Figure 21 shows the exposure of the photoresist material to ultraviolet light through the masks of the laminated assembly shown in Figure 20;

Figure 22 shows the laminate of Figure 21 in cross section following removal of the masks and unexposed photoresist, followed by etching away of the conductive material in the unmasked areas;

Figure 23 shows the laminate of Figure 22 following removal of the hardened photoresist;

Figure 24 shows in sectional view a further step in one embodiment of this invention in which the outer conductive circuit patterns are partially embedded in the substrate material;

Figure 25 shows in section, the subsequent application of a heat-softenable non-conductive metal or alloy material to circuit patterns of the laminate of Figure 24;

Figure 26 shows the reflow by heat softening of the heat-softenable material of Figure 25 to form curved or rounded-off edges to reduce friction between the circuits and the brushes when the laminate becomes the armature in an electric motor;

Figure 27 shows the use of a router to cut out individual armatures from a sheet of laminated material that has been processed as shown in Figures 3 to 23;

Figure 28 shows a top plan view of an individual armature cut out as shown in Figure 27;

Figure 29 is a sectional view taken along the line 29-29 in Figure 28;

Figure 30 is a sectional view taken along the line 30-30 in Figure 28;

Figure 31 is a sectional view taken along the line 31-31 in Figure 28;

Figure 32 is a sectional view taken along the line 32-32 in Figure 28;

Figure 33 is another sectional view through the laminate of Figure 28;

Figure 34 shows the four conductive circuit pattern layers of the laminate of Figure 28 with the substrates not shown to better depict the interconnections between the conductive layers;

Figure 35 is similar to Figure 34, but one or more of the non-conductive substrates are omitted in each quadrant to show the relationship of the four layers of conductive patterns to the substrate layers;

Figure 36 is an explanatory partial sectional view of the prior art armatures of Figures 1 and 2, showing the undesirably greater air gap required by welded tip connections between layers of conductive circuit patterns;

Figure 37 is a side sectional view of one version of an electric motor containing the armature of this invention as made according to the foregoing description;

Figure 38 is a partial sectional view of another embodiment showing the brushes on opposite sides of the armature of this invention;

Figure 39 is an exploded partial view showing the armature of this invention, mounting shaft, and magnetic ring;

Figure 40 is a section through a motor wherein two of the armatures having the construction according to this invention are carried on a common shaft;

Figure 41 shows in an exploded, perspective view the shaft, armatures and stationary central magnetic ring of the motor of Figure 40;

Figure 42 is a sectional view of another embodiment wherein there are two armatures each independently mounted and rotatable on its own shaft to allow speed differentials between armatures;

Figure 43 is an exploded view of the shafts, armatures and stationary magnetic ring of the motor of Figure 42;

Figure 44 is a sectional view through one of the armatures and its shaft in the motor of Figures 42 and 43;

Figure 45 is a plan view of an embodiment of the armature of the present invention provided with reinforcing ribs.

Before commencing manufacture of the pancake armature according to the invention, the conductive cladding material and the insulating substrate are selected, based on the intended end use. The proposed horse power, torque, revolutions per minute and other required characteristics are defined, and the thickness and diameter of the armature are determined, based on space constraints, to determine the thickness of the substrate and cladding.

Referring to the drawings, the insulating substrate layer 10 is laminated to inner conductive cladding layers 12 and 14, using a conventionally appropriate selection of heat, pressure and adhesive layers, as required by the materials involved. Then based on the criteria discussed above, the desired circuit patterns for the inner conductive cladding layers are prepared on master masking sheets that are to be used for printing. They are conventionally designed by a suitably programmed computer, which is also programmed to drive the drilling machine that makes the through-holes in the correct locations to establish the proper electrical connections.

Once the laminated combination of a pair of conductive layers and an insulating separator is prepared, and the masking has been designed, it would be possible to drill the through-holes 48 for metallization, in locations indicated by the masking program for electrically interconnecting areas of the conductive layers that will be in registration on opposite faces of the lamination, as shown in Figure 33 (referring to the second hole 48 from the right end of the drawing). To provide the electrical connections, the lamination would then be immersed in a bath and a micro-thin layer of a metal such as copper deposited (by conventional electroless plating) on the surface and inside the holes 48 followed by electroplating.

Normally, according to the invention, the computer program will provide for the drilling and metallization steps for the inner conductive layers to be postponed until outer insulating and conductive layers are added, by arranging the necessary offsetting of the outer conductive layers 36 and 38 to avoid drilling other than where electrical connections are required.

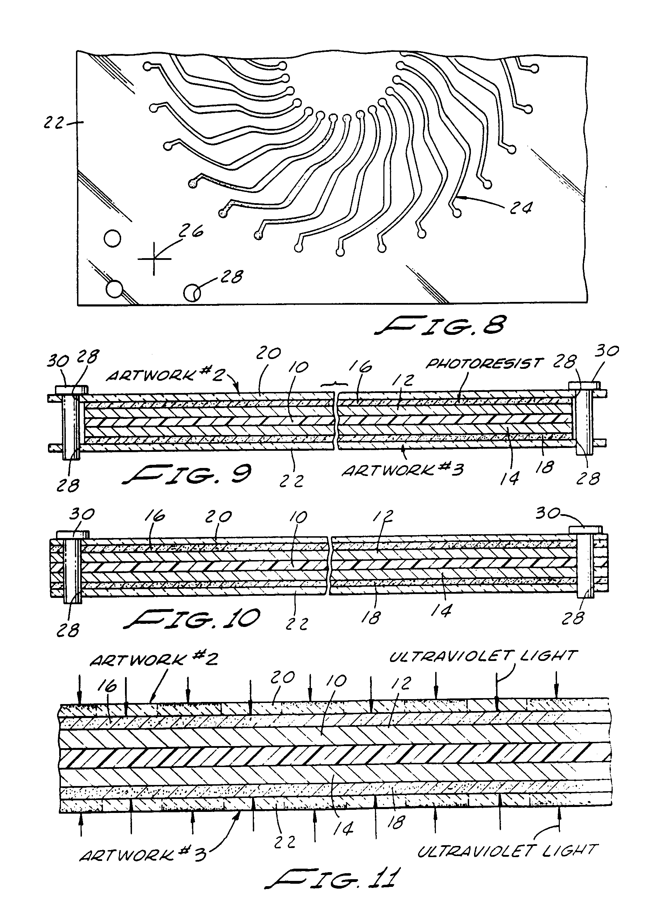

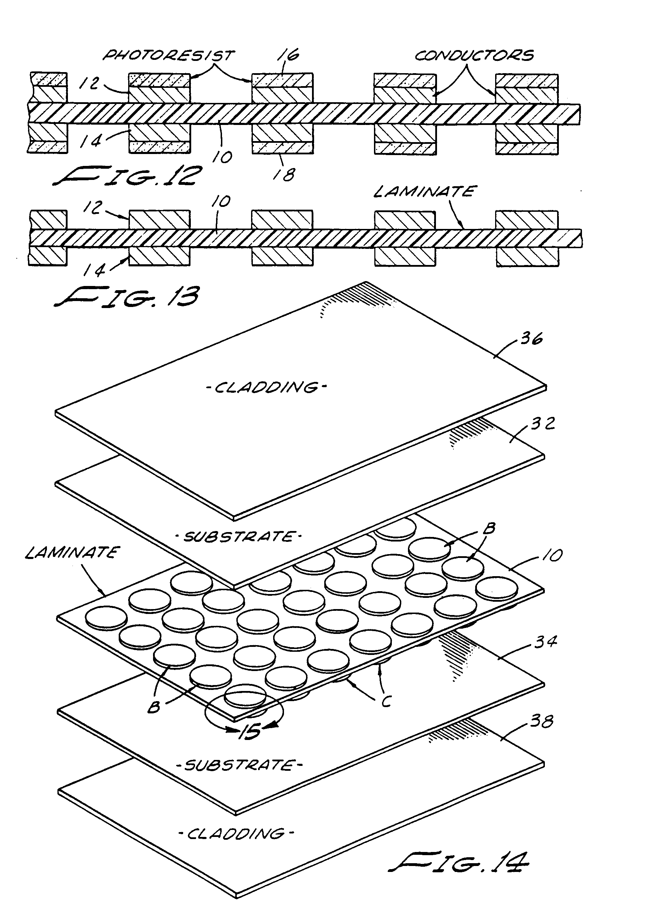

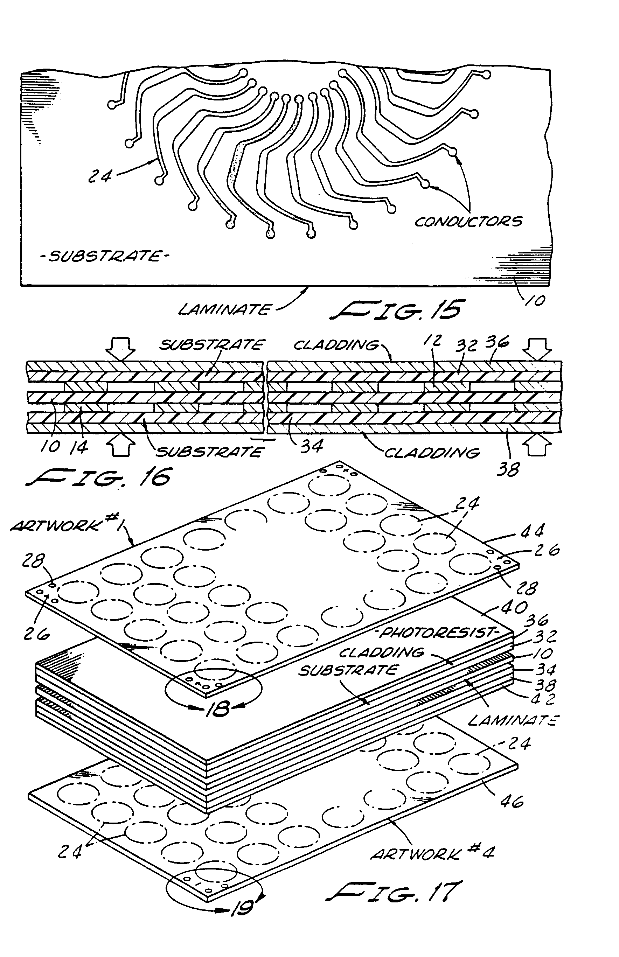

Also according to the invention, the masking sheets, 20 and 22 in Figure 6, are preferably much larger than a single armature (conveniently, about 61cm × 92cm). This enables multiple units of the desired circuit configuration 24 to be produced on each of the masks. Registration of appropriate areas of each mask for through-hole connections may be ensured by holes 28, which can be located in a conventional way by a concentric set of circles or a "cross-hair" pattern, such as shown at 26.

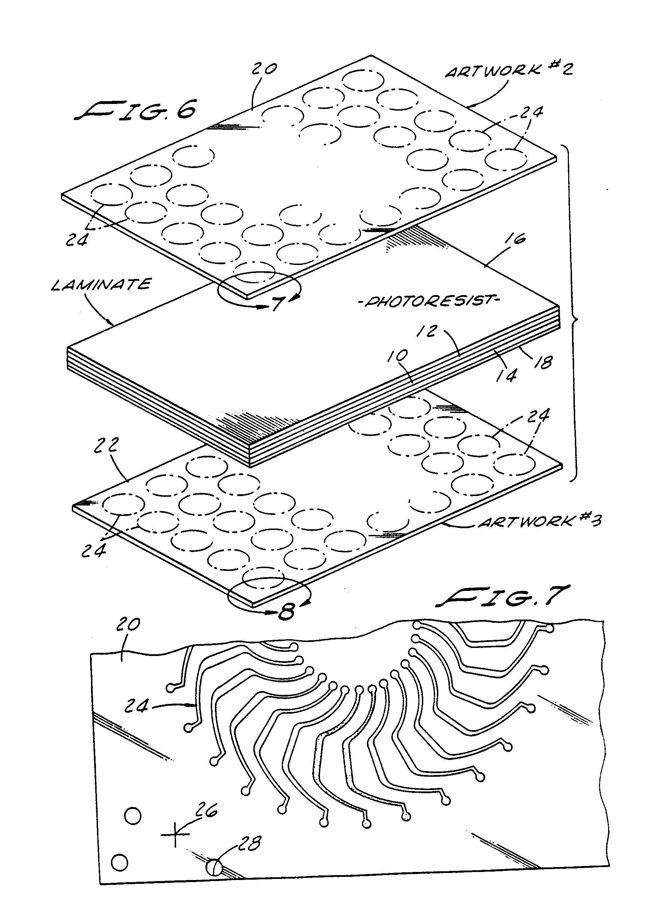

Layers 16 and 18 of photoresist material, which can be in liquid or dry form, are applied as shown in Figure 5. The mask 20 is placed on the top and the complementary mask 22 is placed on the bottom, with the insulating layer in the middle.

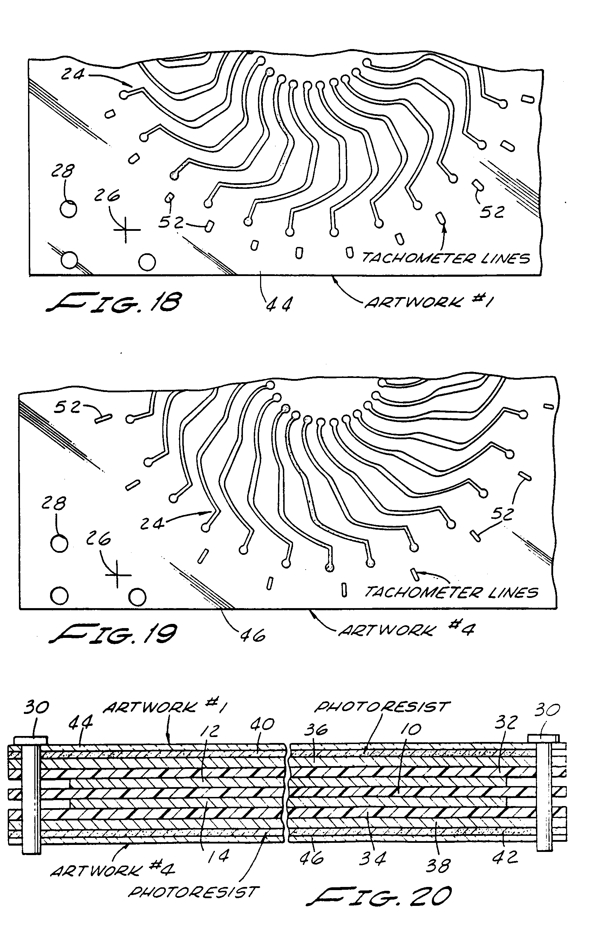

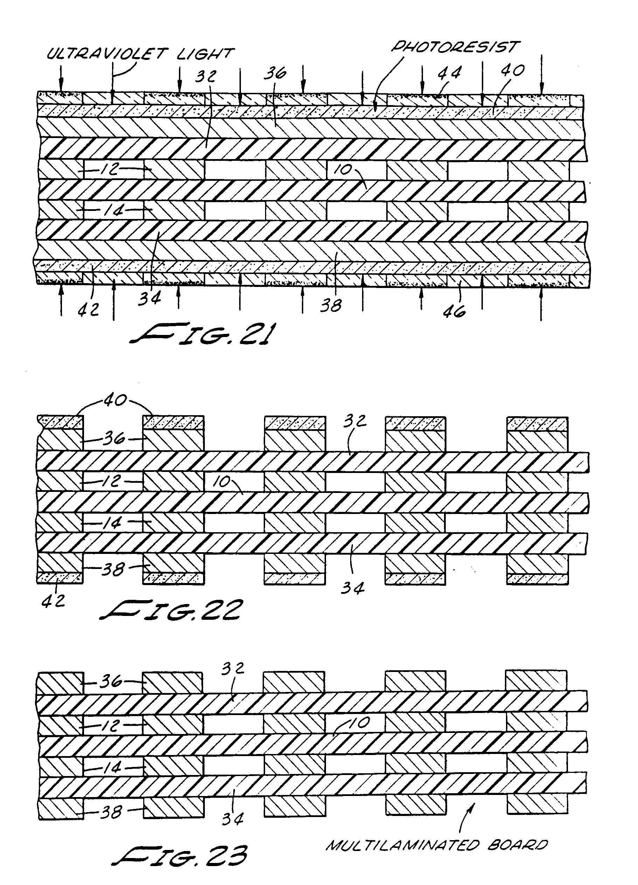

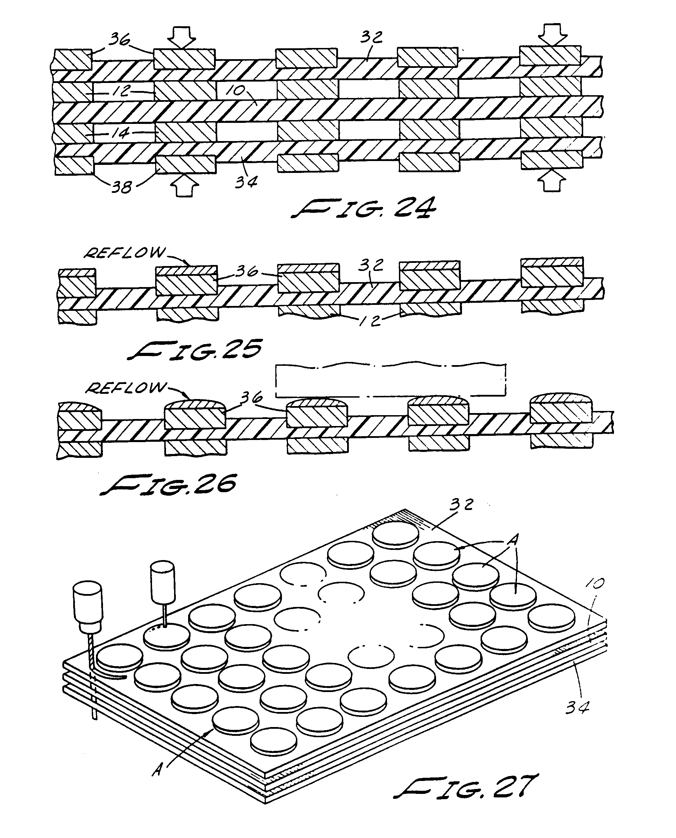

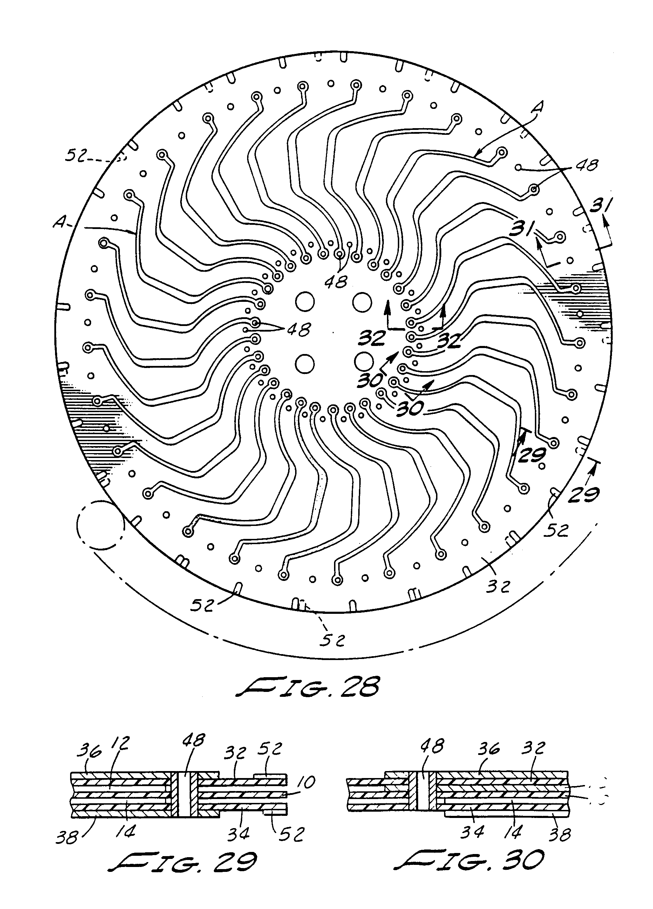

When using holes for registration, as shown in Figures 9 and 10, either the insulating substrate layer 10 is made slightly shorter than the distance between the two holes 28, or the same size as that of the masks 20 and 22 so the holes extend through the insulating substrate layer. Registration pins 30 are inserted in the holes to align and secure the masks.

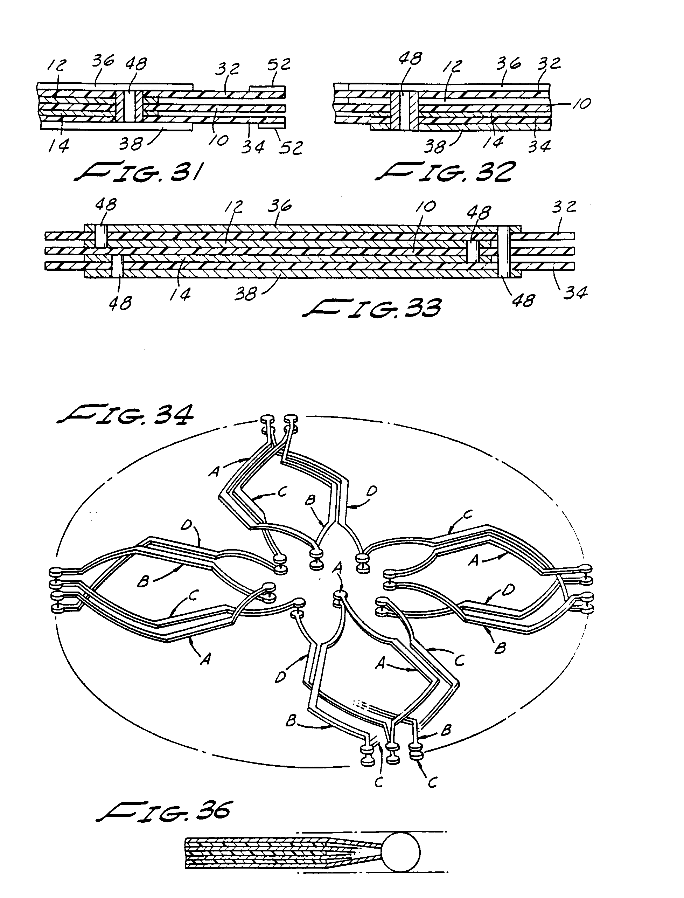

In either case, the assembly is exposed to ultraviolet light to print the images on the photoresist material as shown in Figure 11. The masks are removed and the printed image is developed, using conventional equipment commercially available and designed for the purpose.

The unexposed areas of the developed photoresist are stripped away in a suitable solvent and the exposed metal is removed by etching, leaving the areas that will be part of the circuit pattern. The inner laminate now has on opposite faces complementary half-turn electric circuit patterns that conform respectively to those originally present on masks 20 and 22.

As will be apparent to those familiar with the technical field involved, the conductive circuit patterns could be deposited through silk screen or other masked printing techniques to create the conductive images. Also, each conductive layer could be individually printed by any suitable technique on an insulating layer and adhesively assembled, rather than printed, to form the desired number of paired layers.

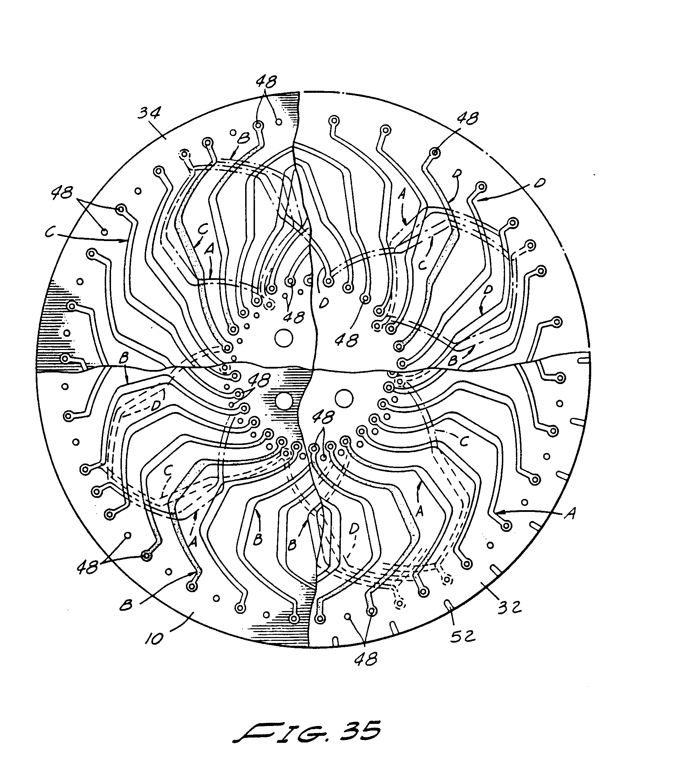

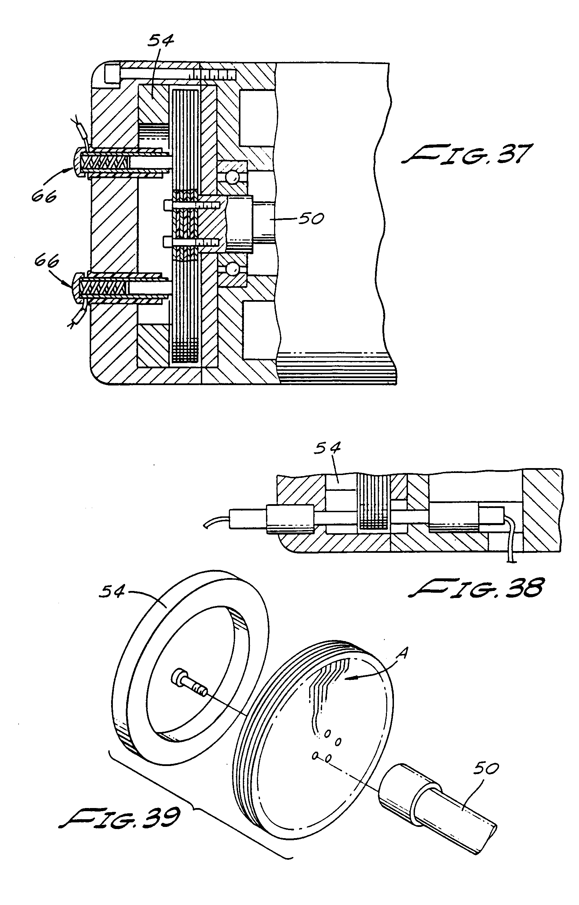

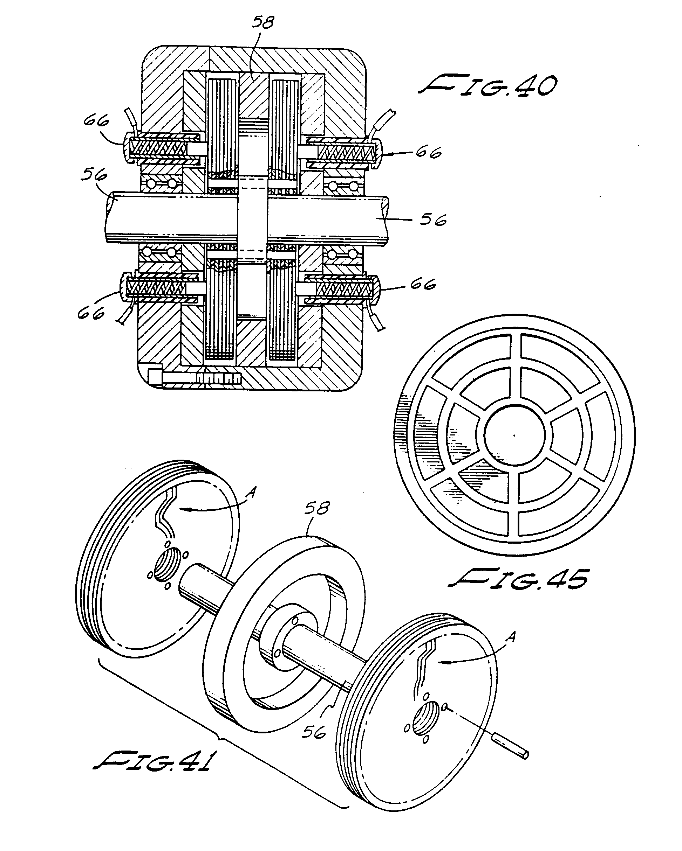

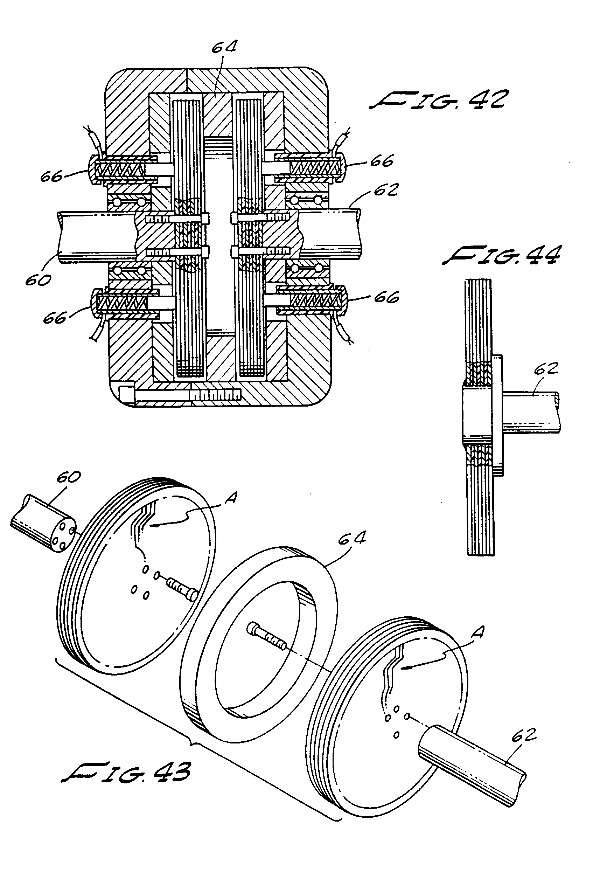

The laminate of inner conductive layers as partially shown in Figure 13 is then ready for multilayer lamination as shown in Figures 14 through 16. An outer insulating separator shown as 32 and 36 and a sheet of conductive cladding material shown as 34 and 38 are respectively, placed in contact with each of the previously printed half-turn electric circuit patterns, and heat and pressure are applied (with interleaved adhesive material if required), and heat and pressure is applied with a hydraulic or vacuum lamination press to adhesively bond the layers of the assembly together and form a multilayer laminate.

The multilayer laminate can now be drilled to provide through-holes 48 for metallization, in locations of the outer masking that are designed to be in registration for electrical interconnection with each other on opposite faces, as shown in Figures 29 and 33, or with the complementary area of the respectively adjacent previously printed inner electric circuit pattern, as shown in Figures 30, 32 and 33. If the drilling and metallization steps for the two previously printed half-turn electric circuit patterns were postponed until the outer insulating and conductive layers were added, the drilling through all the insulating layers where the inner conductors 12 and 14 are in registration but outer conductors 34 and 38 are not in registration with either of them, as shown in Figure 31, will also have to be done.

To provide electrical connections through the drilled holes, the lamination is immersed in a bath and a micro-thin layer of a metal such as copper is deposited (by conventional electroless plating) on the surface and inside the holes 48, followed by electroplating. A resist coating may be applied first to selectively plate the conductor area only or the entire surface may be plated. If desired, a wear-resistant or oxide-resistant metal coating can be applied next in a conventional plating operation.

On each face of the plated multilayer laminate a layer of photoresist material (shown as 40 and 42) and a mask (shown as 44 and 46) having areas opaque to ultraviolet light corresponding to and having complementary areas in registration with the adjacent layer of the said previously printed electric circuit patterns are applied, as shown in Figures 17 through 20.

After plating, the assembly is exposed to ultraviolet light to print the images on the photoresist material as shown in Figure 20. The masks are then removed and the printed image is developed, using conventional equipment. The unexposed areas of the developed photoresist are then stripped away in a suitable solvent and the exposed metal is removed by etching, leaving intact the areas that will be part of the circuit pattern. The multilayer laminate now has on opposite faces complementary half-turn electric circuit patterns that conform respectively to those originally present on masks 44 and 46, and that are parts of a single continuous electrical circuit.

As will be apparent to those familiar with the technical field involved, the conductive circuit patterns could be deposited through silk screen or other masked printing techniques to create the conductive images. Also, each conductive layer could be individually printed by any suitable technique on an insulating layer and adhesively assembled, rather than printed, to form the desired number of paired layers.

The four interconnected layers of conductive circuit patterns are respectively designated in Figures 34 and 35 as A, B, C and D (from top to bottom of the laminate). The finished multilayer laminate of Figure 22 is sometimes referred to as a multilayer board or "MLB".

One of the major maintence problems for electric motors is replacement of the brushes, which are made of resistive carbon material that makes physical contact with the armature to provide a conduit for the electric power. To ensure a good contact, the brush is pressed against the armature with a spring as seen in Figures 37 and 42.

(In Figures 37 through 44, the motor brushes are generally designated by numeral 66). In case of the pancake armature, there is a groove between the conductors where the metal has been etched away, and the conductors have sharp edges (as is shown in Figure 23). As the armature rotates, the spring pressure causes the brush to scrape against these edges and dislodges carbon particles from the brush, which are deposited in the groove between the conductors. Since there is electrical current flowing through the conductors, these particles form a highly resistive short circuit between the conductors, and the brushes need to be replaced frequently.

Armatures made according to this invention can be modified to improve the performance of the brushes, by incorporating in each of the insulating separators on which the two outer conductive layers are applied an outer surface layer of material that is softer than the remainder of the insulating separators. For instance, the insulating layer just below the outer conductive layer may have a higher concentration of uncured resin at its surface than is present in the interior. When the MLB is placed in a heated lamination press, the heat softens the uncured resin and the pressure pushes the conducting material 36 into the resin layer as shown in Figure 24. It is possible to control the depth of penetration of the conductors by controlling the composition of the resin and the pressure. The armature thus manufactured will cause less brush wear because of the lower profile of the conductor pattern.

Of course, the performance of the brushes can be improved by incorporating a wear-reducing coating on the conductive cladding metal. For example, a composite metal made from a layer of wear-reducing metal, such as nickel, over a more conductive metal such as copper may be used as the conductive layer. Alternatively, a layer of wear-reducing metal can be electroplated over the conductive layer as already mentioned. Some low-melting alloys, such as tin-lead, can reduce the brush wear if plating with the alloy is followed with exposure to a suitably high temperature by infrared or hot oil heating. This causes the plating to flow and form a smooth, uniform layer with a meniscus that covers the sharp edges of the conductive layer. Figures 25 and 26 show the plated surface before and after heating.

As indicated above, it is desirable to incorporate multiple units of armature laminates in the MLB, by etching or depositing a predetermined plurality of discrete electric circuit patterns in spaced-apart relationship on the original insulating layer or substrate and on the outer layers of the final assembly. The resulting multilayer laminate is cut into a plurality of circles each comprising one pancake armature, using a blanking die or a router, as shown in Figure 27.

Before cutting the laminate, it is possible to perform electrical tests on the individual layers and optically inspect it to locate defects in the circuit. This will allow early elimination of defective sections.

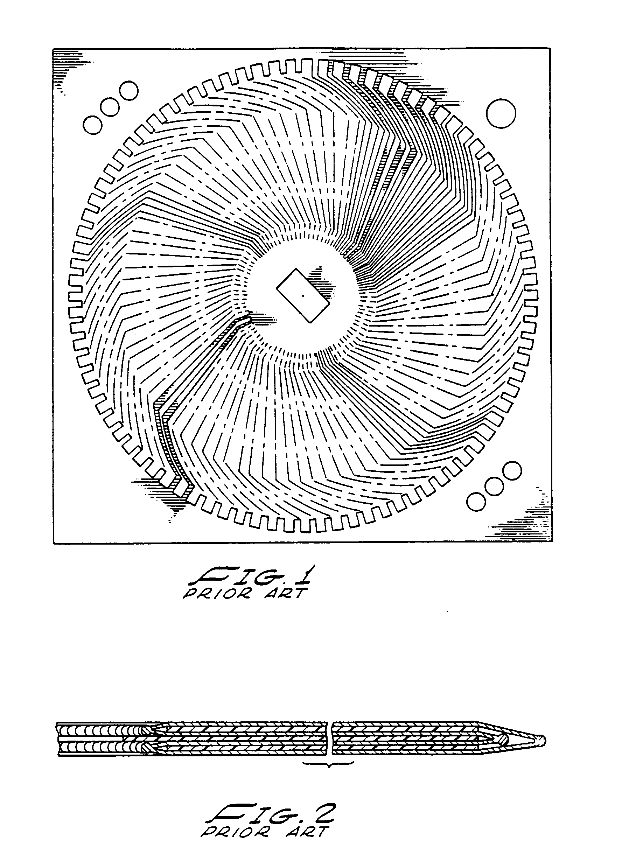

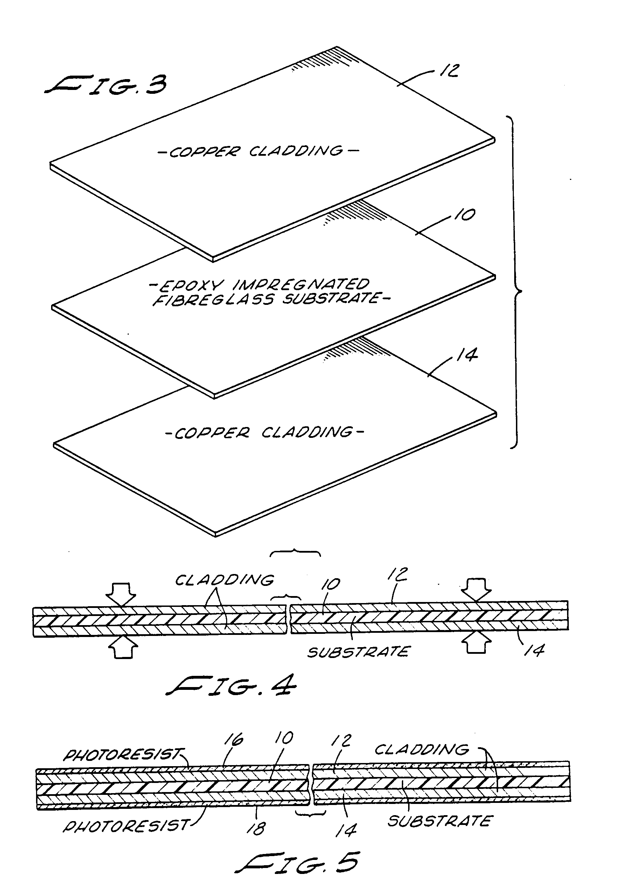

A pancake armature according to the invention can be installed directly on the end of a shaft 50 without any elaborate structure to ensure concentricity such as are necessitated by the circuit welds in the inner diameter of the conventional annular armatures of Figures 1, 2 and 36, which require elaborate tooling to mount them in a plane perpendicular to the shaft. Figures 37 through 39 show one embodiment according to the invention. The interconnections can be achieved by using the plated through-holes, which are positioned so as not to interfere with shaft connections, to mount the armature directly on the end of the shaft or on a hub. Additional holes can be drilled in the center region along with the plated through-holes. Normally, if the holes are drilled on a plurality of armatures in an uncut MLB, the use of a suitable template ensures consistent mounting of all the armatures.

It may be desirable to etch or deposit near the periphery of the armature short radial lines to reflect a source of light and act as a tachometer. A pair of light emitting diodes mounted on the magnet 54 (Figure 37) in a motor will make the tachometer functional. To increase the optical contrast, it is possible to use dark pigmented substrate and/or plate reflective metal over the tachometer lines 52. If both outer layers have tachometer lines 52, it is possible to have a different number of lines on each face. This allows two different tachometer ratings to be used on the same armature.

As shown in Figures 40 and 41, two armatures according to the invention can be mounted on a shaft 56 with a so-called "pancake" magnet 58 in the center. This arrangement will increase torque. As shown in Figures 42 through 44, if two armatures are mounted on two shafts 60 and 62 (on a common center line), it is possible to have two motors sharing one magnet 64. In that case, the same magnet can drive two motors. For example, if the dual disk drives of a personal computer are designed as shown in Figures 42 through 44, then it is possible to drive both units simultaneously or one at a time as desired, and present a very low profile.

## Claims

1. A method for making a pancake armature comprising using print masking to etch or deposit on both sides of an insulating separator (10) a half-turn electric circuit pattern and thereby create a pair of conductive layers (12, 14) on the insulating separator (10), and electrically interconnecting the conductive layers by a metallized hole (48) extending through the conductive layers and the insulating separator, characterized in that an outer insulating separator (32, 36) is placed in contact with each of the pair of conductive layers (12, 14) and an additional conductive layer having areas in registration with the adjacent one of the said previously printed electric circuit patterns is applied to each of the outer insulating separators by using similar masking to etch or deposit on the outer insulating separators complementary outer half-turn electric circuit patterns, the insulating outer separators (32, 36) are adhesively laminated to the conductive layers (34, 38) to form a rigid unitary multilayer laminate, and each of the said outer half-turn electric circuit patterns is connected to the adjacent one of the said previously printed half-turn electric circuit patterns by a metallized hole (48) extending through the respective conductive layers and the outer insulating separator to unite the four printed electric circuit patterns into a single continuous electrical circuit.

2. A method for making a pancake armature as claimed in claim 1, further characterized in that the assembly of the unitary multilayer laminate includes the steps of applying the outer insulating separator (32, 36) and a sheet of conductive material, interleaving adhesive material, applying heat and pressure to adhere the layers of the assembly together, applying on each face of the multilayer laminate a layer of photoresist material and a printing mask having areas opaque to ultraviolet light corresponding to and in circuit registration with the said electric circuit patterns, exposing each face of the multilayer laminate to ultraviolet light, removing the masks (20, 22, 44, 46), washing and etching each face, and removing the masks and unexposed photoresist material.

3. A method for making a pancake armature as claimed in claim 1 or 2, further characterized in that in each of the insulating separators (32, 36) on which the two outer conductive layers (34, 38) are printed is incorporated an outer surface layer of material that is softer than the other material of the insulating separators, and pressure is applied to both conductive faces of the unitary multilayer laminate to embed at least partially the projecting outer electric circuit patterns into the said softer surface layer.

4. A method for making a pancake armature as claimed in claim 1, 2, or 3, further characterized in that a predetermined number of half-turn electric circuit patterns are etched or deposited in spaced-apart relationship on both sides of the insulating separator, which with the other components of the unitary multilayer laminate and the layer of photoresist material are dimensioned to comprise the same number of pancake armatures, and the steps in the assembly of the multilayer laminate include applying on each of its faces a mask (20, 22, 44, 46) having the same number of areas opaque to ultraviolet light corresponding to and in circuit registration with the said half-turn electric circuit patterns, and after the masks (20, 22, 44, 46) are removed the multilayer laminate is cut into a plurality of circles each comprising one pancake armature.

5. A method for making a pancake armature as claimed in claim 1, 2, or 3, further characterized in that short radial lines are etched or deposited near the periphery of the armature to reflect a source of light and act as a tachometer.

6. A pancake armature suitable for use in an electric motor, comprising a pair of half-turn electric circuit patterns etched or deposited on a self-supporting insulating separator (10) and electrically interconnected by through-hole conductive connections (48) each passing through the insulating separator (10) to unite the printed electric circuit patterns into a single continuous electrical circuit, characterized in that it comprises a rigid laminate constituted by two or more pairs of half-turn electric circuit patterns etched or deposited on three or more insulating separators (10, 32, 36) and electrically interconnected by through-hole conductive connections (48) each passing through one insulating separator to unite the printed electric circuit patterns into a single continuous electrical circuit.

7. A pancake armature as claimed in claim 5, further characterized in that an outer half-turn electric circuit pattern is etched or deposited on an outer insulating separator (32, 36) that is laminated on each face of the laminated pair of conductive layers and each of the said outer half-turn electric circuit patterns is in complementary registration with and electrically connected by through-hole conductive connections (48) to the adjacent one of the said previously printed half-turn electric circuit patterns by metallized holes extending through the respective conductive layers (12, 14) and the outer insulating separator (32, 36) and uniting the four printed electric circuit patterns into a single continuous electrical circuit.

8. A pancake armature as claimed in claim 5, 6, or 7, further characterized in that the material of the outer surface layer of each of the insulating separators (10, 32, 36) adjacent the two outer conductive layers (12, 14) is softer than the remainder of the said insulating separators, and the projecting outer electric circuit patterns is at least partially embedded in the said softer surface layer.

9. A pancake armature as claimed in any of claims 5, 6, 7, or 8, further characterized in that the outer extremities of the electric circuit patterns that are etched or deposited on the insulating separators (10, 32, 36) are spaced from the periphery of the laminate constituting the armature.

## Patentansprüche

1. Verfahren zur Herstellung eines scheibenförmigen Ankers, bestehend aus der Verwendung einer Druckmaskierung, um auf beiden Seiten eines isolierenden Distanzelements (10) ein elektrisches Halbwindungs-Schaltkreismuster zu ätzen oder abzulagern und dadurch zwei leitende Schichten (12,14) auf dem isolierenden Distanzelement (10) zu bilden, und aus dem elektrischen Verbinden der leitenden Schichten durch eine metallisierte Bohrung (48), die sich durch die leitenden Schichten und das isolierende Distanzelement erstreckt, dadurch gekennzeichnet, daß ein äußeres isolierendes Distanzelement (32, 36) mit jeder der beiden leitenden Schichten (12,14) in Kontakt gebracht wird, und daß eine zusätzliche leitende Schicht, die mit dem benachbarten Bereich der zuvor gedruckten Schaltkreismuster übereinstimmende Bereiche aufweist, auf jedes der äußeren Distanzelemente durch Anwendung einer ähnlichen Markierung aufgebracht wird, um auf den äußeren isolierenden Distanzelementen komplementäre äußere elektrische Halbwindungs-Schaltkreismuster zu ätzen oder abzulagern, daß die isolierenden äußeren Distanzelemente (32, 36) anhaftend auf die leitenden Schichten (34, 38) laminiert werden, um ein stabiles, einheitliches Mehrschichtlaminat zu bilden, und daß jedes der äußeren elektrischen Halbwindungs-Schaltkreismuster mit dem benachbarten der zuvor gedruckten elektrischen Halbwindungs-Schaltkreismuster durch eine metallisierte Bohrung (48) verbunden wird, die sich durch die jeweiligen leitenden Schichten und das äußere isolierende Distanzelement erstreckt, um die vier gedruckten elektrischen Schaltkreismuster zu einem einzigen kontinuierlichen elektrischen Schaltkreis zu verbinden.

2. Verfahren zur Herstellung eines scheibenförmigen Ankers nach Anspruch 1, dadurch gekennzeichnet, daß der Zusammenbau des einheitlichen Laminats die Schritte des Aufbringes des äußeren isolierenden Distanzelements (32, 36) und einer Folie aus leitendem Material, des Einschichtens von Klebstoff, der Anwendung von Wärme und Druck, um die Schichten der Anordnung miteinander zu verbinden, des Aufbringens auf jeder Seite des Mehrschichtmaterials einer Schicht Fotowiderstandsmaterials und einer Druckmaske, die für UV-Licht undurchlässige Bereiche entsprechend den und in Schaltkreis-Übereinstimmung mit den genannten elektrischen Schaltkreismustern hat, des Belichtens jeder Seite des Mehrschichtlaminats mit UV-Licht, des Entfernens der Masken (20, 22, 44, 46), des Waschens und Ätzens jeder Seite, und des Entfernens der Masken und des unbelichteten Fotwiderstnadsmaterials umfaßt.

3. Verfahren zur Herstellung eines scheibenförmigen Ankers nach Anspruch 1 oder 2, dadurch gekennzeichnet, daß in jedem isolierenden Distanzelement (32,36), auf dem die beiden äußeren leitenden Schichten (34, 38) gedruckt sind, eine Außenflächenschicht aus Material, das weicher als das andere material der isolierenden Distanzelemente ist, aufgebracht wird, und daß beide leitenden Seiten des einheitlichen Mehrschichtlaminats mit Druck beaufschlagt werden, um wenigstens teilweise die vorstehenden äußeren elektrischen Schaltkreismuster in der weicheren Oberflächenschicht einzubetten.

4. Verfahren zur Herstellung eines scheibenförmigen Ankers nach Anspruch 1, 2 oder 3, dadurch gekennzeichnet, daß eine vorbestimmte Anzahl von elektrischen Halbwindungs-Schaltkreismustern beabstandet auf beiden Seiten des isolierenden Distanzelements geätzt oder abgelagert wird, die mit den anderen Komponenten des einheitlichen Mehrschichtlaminats und der Schicht Fotowiderstandsmaterials so dimensioniert werden, daß sie die gleiche Anzahl von scheibenförmigen Ankern umfassen, und daß die Schritte beim Zusammenbau des Mehrschichtlaminats das Aufbrigne einer Maske (20, 22, 44, 46) auf jeder Seite umfaßt, die die gleiche Anzahl von UV-Licht-undurchlässigen Bereichen entsprechend den und in Schaltkreisübereinstimmung mit den Halbwindungs-Schaltkreismustern hat, und daß nach Entfernen der Masken (20, 22, 44, 46) das Mehrschichtlaminat in mehrere Kreis geschnitten wird, von denen jeder einen scheibenförmigen Ankter umfaßt.

5. Verfahren zur Herstellung eines scheibenförmigen Ankers nach Anspruch 1, 2 oder 3, dadurch gekennzeichnet, daß kurze radiale Linien nahe dem Umfang des Ankers geätzt oder abgelagert werden, um eine Lichtquelle zu reflektieren und als Tachometer zu wirken.

6. Zur Verwendung in einem Elelektromotor geeigneter cheibenförmiger Anker, bestehend aus zwei elektrischen Halbwindungs-Schaltkreismustern, die auf einem selbsttragendem, isolierendem Distanzstück (10) geätzt oder abgelagert und durch leitende Durchgangsbohrungs-Verbindungen (48) elektrisch verbunden sind, von denen jede durch das isolierende Distanzelement verläuft, um die gedruckten elektrischen Schaltkreismuster zu einem einzigen kontinuierlichen elektrischen Schaltkreis zu verbinden, dadurch gekennzeichnet, daß er aus einem stabilen Laminat besteht, das sich aus zwei oder mehr Paaren elektrischer Halbwindungs-Schaltkreismuster zusammensetzt, die auf drei oder mehr isolierende Distanzelemente (10), 32, 36) geätzt oder abgelagert und die durch leitende Durchgangsbohrungs-Verbindungen (48) elektrisch leitend verbunden sind, von denen jede durch ein isolierendes Distanzelement verläuft, um die gedruckten elektrischen Schaltkreismuster zu einem einzigen kontinuierlichen elektrischen Schaltkreis zu verbinden.

7. Scheibenförmiger Anker nach Anspruch 5, dadurch gekennzeichnet, daß ein äußeres elektrischen Halbwindungs-Schaltkreimuster auf einem äußeren isolierendem Distanzelement (32,36) geätzt oder abgelagert ist, das auf jede Seite des laminierten Paars leitender Schichten laminiert ist, und daß jedes der äußeren elektrischen Schaltkreismuster in komplementärer Übereinstimmung und durch leitende Durchgangsbohruengs-Verbindungen (48) mit dem benachbarten der genannten, zuvor gedruckten elektrischen Halbwindungs-Schaltkreismuster mittels metallisierter Bohrungen elektrisch verbunden ist, die sich durch die jeweiligen leitenden Schichten (12,14) und das äußere isolierende Distanzelement (32,36) erstrecken und die vier gedruckten elektrischen Schaltkreismuster zu einem einzigen kontinuierlichen elektrischen Schaltkreis verbinden.

8. Scheibenförmiger Anker nach Anspruch 5, 6 oder 7, dadurch gekennzeichnet, daß das Material der Außenflächenschicht der isolierenden Distanzelemente (10, 32, 36) nahe den beiden äußeren Schichten (12,14) weicher als das der übrigen isolierenden Distanzelemente ist, und daß die vorstehenden äußeren elektrischen Schaltkreismuster wenigstens teilweise in der weicheren Oberflächenschicht eingebettet sind.

9. Scheibenförmiger Anker nach einem der Ansprüche 5, 6, 7 oder 8, dadurch gekennzeichnet, daß die äußeren Enden der elektrischen Schaltkreismuster, die auf den isolierenden Distanzelementen (10, 32, 36) geätzt oder abgelagert sind, vom Umfang des den Anker bildenden Laminats entfernt sind.

**Revendications**

1. Un procédé de fabrication d'une armature de galette comprenant les étapes consistant à utiliser un masquage par impression,afin de graver ou déposer sur les deux côtés d'un séparateur isolant (10) une configuration de circuit électrique en demi-tour et de créer ainsi une paire de couches conductrices (12, 14) sur le séparateur isolant (10), et à relier électriquement entre elles les couches conductrices par un trou métallisé (48) traversant les couches conductrices et le séparateur isolant, caractérisé en ce qu'un séparateur isolant extérieur (32, 36) est place en contact avec chacune des couches conductrices (12, 14) de la paire, et une couche conductrice additionnelle, comprenant des zones en alignement avec celle desdites configurations précédemment imprimées de circuit électrique qui est adjacente, est appliquée sur chacun des séparateurs isolants extérieurs en utilisant un masquage semblable afin de graver ou déposer sur les séparateurs isolants extérieurs des configurations complémentaires extérieures de circuit électrique en demi-tour, les séparateurs isolants extérieurs (32, 36) sont laminés de façon adhésive sur les couches conductrices (34, 38) pour former un stratifié multicouche rigide d'un seul tenant, et chacune desdites configurations extérieures de circuit électrique en demi-tour est reliée à celle desdites configurations précédemment imprimées de circuit électrique qui est adjacente par un trou métallisé (48) traversant les couches conductrices respectives et le séparateur isolant extérieur pour réunir en un circuit électrique continu unique les quatre configurations imprimées de circuit électrique.

2. Un procédé de fabrication d'une armature de galette selon la revendication 1, caractérisé en outre en ce que l'assemblage du stratifié multicouche d'un seul tenant inclut les étapes consistant à appliquer le séparateur isolant extérieur (32, 36) et une feuille de matière conductrice, intercaler une matière adhésive, appliquer une chaleur et une pression pour faire adhérer entre elles les couches de l'ensemble, appliquer sur chaque face du stratifié multicouche une couche de matière de résine photosensible et un masque d'impression comprenant des zones opaques à une lumière ultraviolette correspondant auxdites configurations de circuit électrique et en alignement avec elles, exposer chaque face du stratifié multicouche à une lumière ultraviolette, enlever les masques (20, 22, 44, 46), laver et graver chaque face, et enlever la matière des masques et la matière de résine photosensible non exposée.

3. Un procédé de fabrication d'une armature de gelette selon la revendication 1 ou 2, caractérisé en outre en ce qu'une couche superficielle extérieure de matière qui est plus molle que l'autre matière des séparateurs isolants est incorporée dans chacun des isolants séparateurs (32, 36) sur lesquels les deux couches conductrices extérieures (34, 38) sont imprimées, et une pression est appliquée aux deux faces conductrices du stratifié multicouche d'un seul tenant afin d'incorporer au moins partiellement dans ladite couche superficielle plus molle lesdites configurations extérieures de circuit électrique en saillie.

4. Un procédé de fabrication d'une armature de galette selon la revendication 1, 2 ou 3, caractérisé en outre en ce qu'il est gravé ou déposé, dans une relation espacée sur les deux côtés du séparateur isolant, un nombre prédéterminé de configurations de circuits électriques en demi-tour qui sont dimensionnées, avec les autres composants du stratifié multicouche d'un seul tenant et la couche de matière de résine photosensible, pour comprendre le même nombre d'armatures de galettes et les étapes de l'assemblage du stratifié multicouche incluent une application sur chacune de ses faces d'un masque (20, 22: 44, 46) présentant le même nombre de zones opaques à la lumière ultraviolette correspondant auxdites configurations de circuits électriques en demi-tour et en alignement de circuit avec elles, et le stratifié multicouche est coupé en plusieurs cercles comprenant chacun une armature de galette après l'enlèvement des masques (20, 22; 44, 46).

5. Un procédé du fabrication d'une armature de galette selon la revendication 1, 2 ou 3, caractérisé en outre en ce que de courtes lignes radiales sont gravées ou déposées près de la périphérie de l'armature afin de réfléchir une source de lumière et d'agir comme tachymètre.

6. Une armature en galette apte à être utilisée dans un moteur électrique, comprenant une paire de configurations de circuit électrique on demi-tour, gravées ou déposées sur un séparateur isolant se supportant lui-même (10) et électriquement reliées entre elles par des liaisons conductrices (48) à trous traversants, chacune traversant le séparateur isolant (10) pour réunir en un circuit électrique continu unique les configurations imprimées de circuit électrique, caractérisé en ce qu'elle comprend un stratifié rigide constitué par deux paires de configurations de circuit électrique en demi-tour, ou davantage, gravées ou déposées sur trois séparateurs isolants ou davantage (10, 32, 36) et reliées électriquement entre elles par des liaisons conductrices (48) à trous traversants, chacune traversant un séparateur isolant pour réunir en un circuit électrique continu unique les configurations imprimées de circuit électrique.

7. Une armature en galette selon la revendication 5, caractérisée en outre on ce qu'une configuration extérieure de circuit électrique en demi-tour est gravée ou déposée sur un séparateur isolant extérieur (32, 36) qui est laminée sur chaque face de la paire de couches conductrices laminées et chacune desdites configurations extérieure de circuit électrique en demi-tour est en alignement complémentaire avec des liaisons conductrices à trous traversants et reliée électriquement par celles-ci à celle desdites configurations déjà imprimées de circuit électrique en demi-tour qui est adjacente par des trous métallisés qui traversant les couches conductrices respectives (12, 14) et le séparateur isolant (32, 36) et réunissent en un circuit électrique continu unique les quatre configurations imprimées de circuit électrique.

8. Une armature en galette selon la revendication 5, 6, ou 7, caractérisée en outre en ce que la matière de la couche de surface extérieure de chacun des séparateurs isolants (10, 32, 36) adjacent aux deux couches extérieures conductrices (12, 14) est plus molle que le reste desdites séparateurs isolants, et les configurations extérieures de circuit électrique en saillie sont au moins partiellement incorporées dans cette couche superficielle plus molle.

9. Une armature en galette selon l'une quelconque des revendications 5, 6, 7 ou 8, caractérisée en outre ce que les extrémités extérieures des configurations du circuit électrique qui sont gravées ou déposées sur les séparateurs isolants (10, 32, 36) sont espacées de la périphérie du stratifié constituant l'armature.

FIG.1
PRIOR ART

FIG.2
PRIOR ART

*FIG.3*

-COPPER CLADDING- 12

-EPOXY IMPREGNATED FIBREGLASS SUBSTRATE- 10

-COPPER CLADDING- 14

CLADDING 10 12

SUBSTRATE 14

*FIG.4*

PHOTORESIST 16 10 12 CLADDING

PHOTORESIST 18 14 SUBSTRATE

*FIG.5*

FIG.6
ARTWORK #2
LAMINATE
-PHOTORESIST-
ARTWORK #3

FIG.7

**FIG.8**

**FIG.9**

**FIG.10**

**FIG.11**

15

EP 0 277 653 B1

FIG.12

FIG.13

FIG.14

FIG. 15

FIG. 16

FIG. 17

FIG. 18

FIG. 19

FIG. 20

ULTRAVIOLET LIGHT    32    36    PHOTORESIST    44    40

12    10

14

42    34    38    46

FIG.21

40

36    32

12    10

14

38

42    34

FIG.22

36    32

12    10

14

38    34

MULTILAMINATED BOARD

FIG.23

FIG. 24

FIG. 25

FIG. 26

FIG. 27

FIG. 28

FIG. 29

FIG. 30

FIG. 31

FIG. 32

FIG. 33

FIG. 34

FIG. 36

FIG. 35

*FIG.37*

*FIG.38*

*FIG.39*

FIG.40

FIG.45

FIG.41

64

*FIG. 42*

66

66

62

66

60

66

*FIG. 44*

62

60

*A*

64

62

*A*

*FIG. 43*